# EUROPEAN PATENT APPLICATION

(11) **EP 3 012 859 A1**
(43) Date of publication of application: **27.04.2016**
(21) Application number: 14814010.6
(22) Date of filing: 22.04.2014
(51) Int. Cl.: H01L 21/677, C23C 16/458, H01L 21/205, H01L 21/683

(54) **DEVICE AND METHOD FOR TRANSFERRING SUBSTRATE FOR FORMING COMPOUND SEMICONDUCTOR FILM, AND SYSTEM AND METHOD FOR FORMING COMPOUND SEMICONDUCTOR FILM**

(30) Priority: 17.06.2013 JP 2013126826
(71) Applicant: Tokyo Electron Limited, Tokyo 107-6325 (JP)
(72) Inventor: MORISAKI, Eisuke, Nirasaki-shi, Yamanashi 407-8511 (JP); KIMOTO, Tomohisa, Nirasaki-shi, Yamanashi 407-0192 (JP)
(74) Representative: Hoffmann Eitle
(86) International application number: PCT/JP2014/061261
(87) International publication number: WO 2014/203613

(57) **Abstract**

A transferring device includes a supporting part configured to support a substrate holder, an elevation member configured to raise and lower a substrate at a substrate holding portion of the substrate holder, and a shielding member configured to be raised and lowered by the elevation member. The shielding member is interposed between the substrate and the elevation member when the elevation member receives the substrate. When the substrate is held on the substrate holding portion, the shielding member shields, at a backside of the substrate, a hole in the substrate holder through which the elevation member is inserted. In a state where the elevation member is raised, the substrate is mounted on the shielding member, or the substrate on shielding member is transferred therefrom.

## Description

### Field of the Invention

The present invention relates to a device and a method for transferring a substrate for forming a compound semiconductor film thereon, and a system and a method for forming a compound semiconductor film.

### Background of the Invention

A compound semiconductor such as SiC, GaN, GaAs, AlN or the like attracts attention as a next generation semiconductor, because it can save more energy and realize more miniaturization compared to Si. In manufacturing such a compound semiconductor, there is often used a metal-organic vapor phase epitaxy (MOVPE) method for forming, by epitaxial growth, a compound semiconductor film on a substrate by using an organic metal material (see, e.g., Japanese Patent Application Publication No. 2001-024221).

In the case of forming the compound semiconductor film by the MOVPE method, it is required to perform the film formation for a long period of time at a high temperature of 1000°C or above in order to allow a single crystal having the same orientation as that of a substrate crystal to grow on the substrate while maintaining good crystalline.

Thus, semi-batch type film formation for processing a plurality of substrates on a holder is employed in view of improvement of a throughput, instead of single-sheet film formation such as metal film formation on a silicon substrate or the like, and inductive heating is employed in view of requirement for high-temperature heating (see, e.g., Japanese Patent Application Publication No. 2008-159947).

A processing temperature or a processing type of the compound semiconductor film formation is different from that of the film formation on a silicon substrate. Therefore, a substrate transfer unit used in a conventional silicon substrate processing apparatus cannot be employed for the compound semiconductor film formation. Accordingly, in a conventional compound semiconductor film forming apparatus, a holder is taken out from the apparatus and an operator transfers a substrate for forming a compound semiconductor by using a pincette.

However, when a single crystal grows, crystal defects may occur even by a small number of particles. Therefore, the crystal defects caused by the particles generated when the operator sets the substrate by using the pincette may lead to deterioration of a production yield.

A transferring device for automatically transferring a substrate may be used. However, there is no measure to solve a problem such as adhesion of undesired deposits onto the backside of the substrate or transcription on the backside of the substrate.

### Summary of the Invention

In view of the above, the present invention provides a device and a method for automatically transferring a substrate for forming a compound semiconductor film thereon while preventing an effect of particles or solving a problem such as undesired film formation on a backside of a substrate or transcription on the backside of the substrate, and a system and a method for forming a compound semiconductor film.

In accordance with a first aspect of the present invention, there is provided a transferring device for transferring a substrate for forming a compound semiconductor film thereon to a substrate holder. The transferring device includes a supporting part, an elevation member, and a shielding member. The supporting part is configured to support the substrate holder. The elevation member is configured to raise and lower a substrate at a substrate holding portion of the substrate holder. The shielding member is configured to be raised and lowered by the elevation member. The shielding member is interposed between the substrate and the elevation member when the elevation member receives the substrate. The shielding member shields, at a backside of the substrate, a hole in the substrate holder through which the elevation member is inserted when the substrate is held on the substrate holding portion. In a state where the elevation member is raised, the substrate is mounted on the shielding member or the substrate on the shielding member is transferred therefrom.

The substrate holder preferably includes a plurality of substrate holding portions. In this case, the transferring device preferably further includes a rotation unit configured to rotate the substrate holder to make each of the substrate holding portions correspond to the elevation member.

The transferring device is preferably separately provided from an apparatus for forming a compound semiconductor film. The shielding member may be made of one of TaC, SiC, SiC coat graphite, and graphite.

The transferring device preferably further includes a chamber configured to accommodate the substrate holder and allow transfer of the substrate therein, and a unit for forming a downflow of clean air in the chamber.

In accordance with a second aspect of the present invention, there is provided a transferring method for transferring a substrate for forming a compound semiconductor film thereon. In the transferring method, a substrate holder is prepared. The substrate holder includes a substrate holding portion having a hole through which an elevation member configured to raise and lower a substrate is inserted. The hole is shielded by a shielding member. The shielding member is raised by raising the elevation member. The substrate is mounted on the shielding member and held on the substrate holding portion in a state where the elevation member is lowered and the hole is shielded, at a backside of the substrate, by the shielding member.

In the transfer method, the shielding member and the substrate held on the substrate holding portion are raised from the substrate holding portion by raising the elevation member. The substrate is transported from the shielding member. The shielding member is lowered by lowering the elevation member to shield the hole.

In accordance with a third aspect of the present invention, there is provided a film forming system. The film forming system includes: a transferring device, a film forming apparatus, and a transporting device. The transferring device is configured to transfer a substrate for forming a compound semiconductor film thereon to a substrate holder including a plurality of substrate holding portions. The film forming apparatus is configured to form a compound semiconductor film on a plurality of substrates mounted on the substrate holder, into which the substrate holder on which the substrates are mounted by the transferring device is loaded. The transporting device is configured to transport the substrate holder between the transferring device and the film forming apparatus. The transferring device includes a supporting part, an elevation member, and a shielding member. The supporting part is configured to support the substrate holder. The elevation member is configured to raise and lower a substrate at a substrate holding portion of the substrate holder. The shielding member is configured to be raised and lowered by the elevation member. The shielding member is interposed between the substrate and the elevation member when the elevation member receives the substrate. The shielding member shields, at a backside of the substrate, a hole in the substrate holder through which the elevation member is inserted when the substrate is held on the substrate holding portion. In a state where the elevation member is raised, the substrate is mounted on the shielding member or the substrate on the shielding member is transferred therefrom.

In accordance with a forth aspect of the present invention, there is provided a method for forming a compound semiconductor film on a plurality of substrates for forming a compound semiconductor film thereon. In the method, a substrate holder is prepared. The substrate holder includes a plurality of substrate holding portions, each of which having a hole through which an elevation member configured to raise and lower a substrate is inserted. Each of the holes is shielded by a shielding member. The shielding member raised by raising the elevation member at one of the substrate holding portions. A substrate is mounted on the shielding member by a transporting device. The substrate is held on each substrate holding portion in a state where the elevation member is lowered and the hole is shielded, at the backside of the substrate, by the shielding member. The substrate holder on which the plurality of substrates is held is transported to a film forming apparatus. A compound semiconductor film is formed on the substrates.

In this present invention, the substrate can be automatically transferred to the substrate holder, so that the effect of particles which is caused by an operator's operation can be avoided. In addition, the shielding member is provided at the substrate holder to shield, at the backside of the substrate, the hole through which the elevation member is inserted and passed. Therefore, it is possible to effectively reduce generation of sublimates or deposits on the backside of the substrate during the film formation or effectively suppress transcription of the elevation member or the like on the backside of the substrate. Accordingly, it is possible to prevent a resistance value from being adversely affected during device formation or various measurements from being adversely affected by the deposits.

### Brief Description of the Drawings

Fig. 1 is a schematic diagram showing a system for forming a compound semiconductor film to which the present invention is applied.
Fig. 2 is a schematic diagram showing a configuration of a film forming apparatus of the film forming system shown in Fig. 1.
Fig. 3 is a cross sectional view showing an inside of a processing chamber of the film forming apparatus of the film forming system shown in Fig. 1.
Fig. 4 is a cross sectional view of a transferring device of the film forming system shown in Fig. 1.
Fig. 5 is a top view showing a holder.
Fig. 6 is a cross sectional view of a substrate holding portion of the holder.
Fig. 7 is a cross sectional view showing a state in which the holder is loaded into the processing chamber of the transferring device.
Fig. 8 is a top view showing a state in which the holder is supported by a fork of a transporting device.
Fig. 9 is a top view showing a state in which the substrate is supported by the fork of the transporting device.
Figs. 10A to 10E are process diagrams for explaining a substrate delivery operation (loading operation) in the transferring device.
Figs. 11A to 11D are process diagrams for explaining a substrate receiving operation (unloading operation) in the transferring device.

### Detailed Description of the Embodiments

Hereinafter, embodiments will be described with reference to the accompanying drawings.

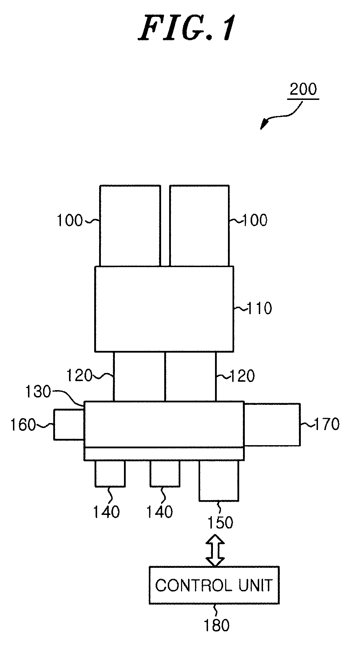

Fig. 1 is a schematic diagram showing a system for forming a compound semiconductor film to which the present invention is applied. Here, a semi-batch type film forming system for forming a SiC film as a compound semiconductor on a substrate (wafer) by epitaxial growth will be described as an example.

A film forming system 200 shown in Fig. 1 includes two film forming apparatuses 100. Each of the film forming apparatuses 100 accommodates a plate-shaped holder on which a plurality of substrates is mounted. Each of the film forming apparatuses 100 forms a SiC film on a plurality of substrates. The two film forming apparatuses 100 are connected to a transfer chamber 110 where a transfer unit (not shown) is provided. Two load-lock chambers 120 are connected to the transfer chamber 110. The number of the film forming apparatuses 100 and the number of the load-lock chambers 120 are not limited to two.

The two load-lock chambers 120 are also connected to a loading/unloading chamber 130 provided at the opposite side to the transfer chamber 110. The loading/unloading chamber 130 has a rectangular shape when seen from the top. Two substrate carriers 140 capable of accommodating a plurality of substrates and a holder carrier 150 capable of accommodating a plurality of holders are connected to a wall of the loading/unloading chamber 130 which is opposite to the wall where the load-lock chambers 120 are connected. The number of the carriers 140 and 150 that can be connected to the loading/unloading chamber 130 may vary.

A positioning device 160 is connected to one sidewall of the loading/unloading chamber 130. A transferring device 170 for attaching/detaching the substrate to/from the holder is connected to the other sidewall of the loading/unloading chamber 130. Provided in the loading/unloading chamber 130 is a transfer unit (not shown) for transferring the substrate and the holder. A single transfer unit may be provided to transfer both of a substrate and a holder. Or, a transfer unit for transferring a substrate and a transfer unit for transferring a holder may be separately provided. Or, a common transfer unit which has a supporting part for transferring a substrate and a supporting part for transferring a holder may be provided.

Gate valves (not shown) are provided between the film forming apparatuses 100 and the transfer chamber 110 and between the load-lock chambers 120 and the transfer chamber 110, and between the load-lock chambers 120 and the loading/unloading chamber 130. The gate valves are capable of allowing or preventing communication therebetween.

The film forming apparatuses 100 and the transfer chamber 110 are maintained in a vacuum state. The loading/unloading chamber 130 is maintained in an atmospheric atmosphere. The load-lock chambers 120 can be switched between a vacuum atmosphere and an atmospheric atmosphere so that the holder can be transferred between the transfer chamber 110 in the vacuum atmosphere and the loading/unloading chamber 130 in the atmospheric atmosphere.

An HEPA filter is installed at a ceiling portion of the loading/unloading chamber 130. Clean air is introduced into the loading/unloading chamber 130 in a downflow manner through the HEPA filter. Therefore, the substrate and the holder are transferred under a clean air atmosphere of the atmospheric pressure. Accordingly, the effect of particles can be minimized. Shutters are installed at installation portions of the substrate carriers 140 and the holder carrier 150. When the substrate carriers 140 and the holder carrier 150 are attached, the shutters are opened to allow them to communicate with the loading/unloading chamber 130 while preventing the introduction of external air.

The components of the film forming system 200, e.g., gas supply systems or gas exhaust systems in the film forming apparatuses 100, the transfer chamber 110, and the load-lock chambers 120, transfer units in the loading/unloading chamber 130 and the transfer chamber 110, gate valves and the like, are controlled by a control unit 180 including a controller having a microprocessor (computer). The control unit 180 further includes, in addition to the controller for performing actual control, a storage unit for storing a process sequence of the film forming system 200 and a process recipe that is a control parameter, an input device, a display, and the like. The control unit 180 is configured to control the film forming system 200 based on a selected process recipe.

In the film forming system configured as described above, first, a substrate carrier 140 accommodating substrates to be subjected to film formation, an empty substrate carrier 140 and a holder carrier 150 accommodating holders are connected to the loading/unloading chamber 130. Then, a holder is unloaded from the holder carrier 150 and transferred to the transferring device 170 by the transfer unit in the loading/unloading chamber 130. Next, a substrate is transferred from the substrate carrier 140 to the transferring device 170 by the transfer unit in the loading/unloading chamber 130. A predetermined number of substrates are transferred to the holder by the transferring device 170.

After the substrate is transferred to the holder, the holder in the transferring device 170 is transferred to any one of the load-lock chambers 120 by the transfer unit in the loading/unloading chamber 130. Then, the load-lock chamber 120 is evacuated to vacuum. Next, the holder in the load-lock chamber 120 is transferred to any one of the film forming apparatuses 100 by the transfer unit in the transfer chamber 110. Thereafter, a SiC film as a compound semiconductor film is formed on the substrates mounted on the holder.

Upon completion of the film formation, the holder is transferred from the film forming apparatus 100 to one of the load-lock chamber 120 by the transfer unit in the transfer chamber 110. The load-lock chamber 120 is set to an atmospheric atmosphere and, then, the holder is transferred to the transferring device 170 by the transfer unit in the loading/unloading chamber 130. The substrates are separated from the holder by the transferring device 170 and accommodated in the empty substrate carrier 140 by the transfer unit. In the same manner, a substrate is transferred to the empty holder of the transferring device 170 and then transferred to the film forming apparatus 100. After the holder is unloaded from the transferring device 170, another holder is loaded and a substrate is transferred in the same manner as described above.

Hereinafter, the film forming apparatus 100 will be described.

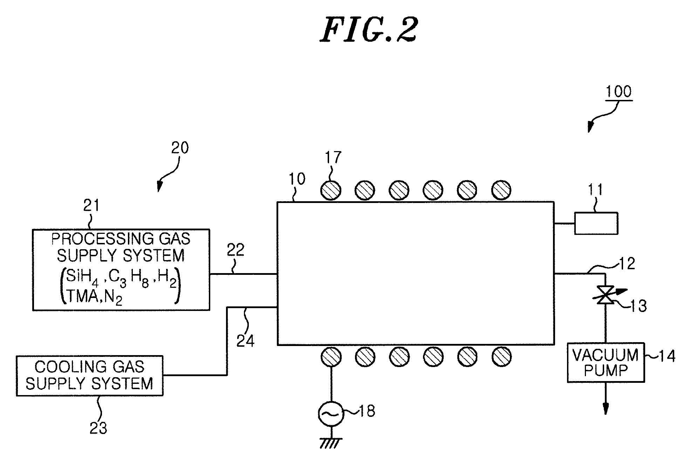

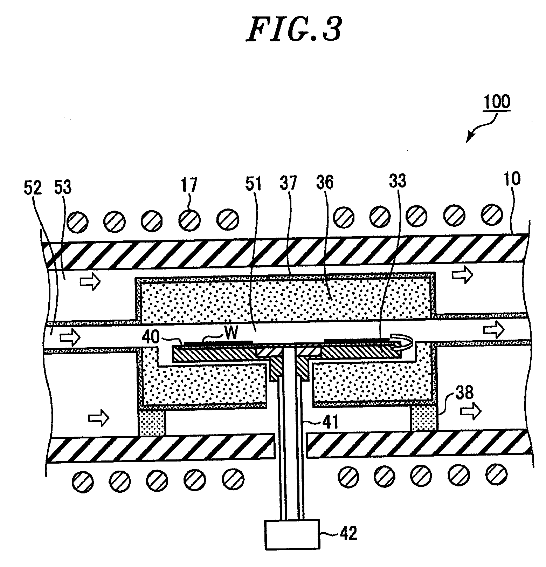

Fig. 2 is a schematic diagram showing a configuration of the film forming apparatus 100. Fig. 3 is a cross sectional view showing an inside of a processing chamber of the film forming apparatus 100. The film forming apparatus 100 includes a substantially rectangular parallelepiped processing chamber 10 having therein a depressurized space where a film is formed on a substrate. The processing chamber 10 is made of a dielectric material such as quartz or the like.

A gas exhaust line 12 is connected to the processing chamber 10. A vacuum pump 14 serving as a gas exhaust device and a conductance variable valve 13 serving as a pressure control device are provided in the gas exhaust line 12. The processing chamber 10 is exhausted through the gas exhaust line 12 by the vacuum pump 14 and controlled to a predetermined vacuum state (depressurized state). A pressure gauge 11 is installed at the processing chamber 10. A pressure in the processing chamber 10 is controlled by the conductance variable valve 13 based on a measurement value of the pressure gauge 11.

An induction heating coil 17 is wound around the processing chamber 10. A high frequency power supply 18 is connected to the induction heating coil 17. By supplying a high frequency power from the high frequency power supply 18 to the induction heating coil 17, the depressurized space in the processing chamber 10 is inductively heated.

The film forming apparatus 100 includes a gas supply unit 20 for supplying a gas into the processing chamber 10. The gas supply unit 20 has a processing gas supply system 21 for supplying a processing gas for film formation. A processing gas supply line 22 extending from the processing gas supply system 21 is connected to the processing chamber 10. Further, the gas supply unit 20 has a cooling gas supply system 23 for supplying an inert gas, e.g., Ar gas, as a cooling gas. A cooling gas supply line 24 extending from the cooling gas supply system 23 is connected to the processing chamber 10.

The processing gas supply system 21 includes: gas supply sources for supplying SiH₄ gas, C₃H₈ gas, H₂ gas, TMA (trimethylaluminum) gas, and N₂ gas; and a gas distribution system extending from the gas sources to the processing gas supply line 22. The gas distribution system has a flow rate controller such as an opening/closing valve, a mass flow controller, and the like. When a SiC film is formed on a substrate by epitaxial growth in the processing chamber 10, SiH₄ gas, C₃H₈ gas, and H₂ gas are supplied as source gases for film formation into the processing chamber 10. If necessary, TMA gas and/or N₂ gas may be supplied to control electrical characteristics of the formed SiC film. The above-mentioned processing gases are examples. The SiC film may be formed by using other gases.

The cooling gas supply system 23 includes a cooling gas supply source, and a flow rate controller such as an opening/closing valve, a mass flow controller and the like which is provided in the cooling gas supply line 24.

As shown in Fig. 3, a mounting table 33 for mounting thereon a substrate holder 40 on which a plurality of substrates W is held is provided in the processing chamber 10. A space above the mounting table 33 serves as a processing space 51 where the film formation is performed by the processing gas.

A heat insulator 36 is provided at the outer side of the mounting table 33 and above the mounting table 33. The heat insulator 36 is supported by a heat insulator holding member 37 that covers the outer side of the heating insulator 36. The heat insulator holding member 37 is supported at the bottom portion of the processing chamber 10 by a supporting block 38. Therefore, the heat insulator holding member 37 is spaced apart from the processing chamber 10. The heat insulator holding member 37 divides the space in the processing chamber 10 into a processing gas space 52 into which the processing gas is supplied and an heat insulating space 53. The processing gas is supplied through the processing gas space 52 and the processing gas supply line 22. The film forming process is performed in the processing space 51. The exhaust gas is discharged from the processing gas space 52 through the gas exhaust line 12. The mounting table 33 is made of a material having high heat resistance, e.g., graphite or SiC, which is easily heated by induction heating and can easily heat the substrate W by radiant heat. The heat insulator 36 is made of, e.g., a porous carbon-based material. The heat insulator holding member 37 and the supporting block 38 are made of, e.g., quartz. The components provided in the processing chamber 10 are made of a high-purity material so that the substrate W is protected from contamination.

A hole is formed at a central portion of the mounting table 33 so that a rod 41 can be inserted thereinto. The rod 41 extends to a position under the processing chamber 10, and can be vertically moved and rotated by a driving unit 42. The rod 41 has a dual structure. An upper end of the central portion of the rod 41 is fitted into a hole formed at the center of the substrate holder 40. The substrate holder 40 can be lifted in a state where the rod 41 is fitted in the hole. When the substrate holder 40 is transferred, the substrate holder 40 can be lifted by raising the central portion of the rod 41. During the film formation, the substrate holder 40 is rotated through the mounting table 33 by rotating the rod 41.

In the film forming apparatus 100 configured as described above, the high frequency power is supplied from the high frequency power supply 18 to the induction heating coil 17 in a state where the substrate holder 40 on which the substrate W is held is mounted on the mounting table 33. Accordingly, the temperature of the mounting table 33 is increased by induction heating.

The mounting table 33 is made of a material having high heat resistance, e.g., graphite, SiC or the like, which is easily heated by induction heating and can easily heat the substrate W by radiant heat. Since the mounting table 33 is thermally insulated from the processing chamber 10 by the heat insulator 36, the substrate W can be effectively heated to a high temperature ranging from 1550° C to 1650°C, for example.

In a state where the substrate W is heated, SiH₄ gas, C₃H₈ gas, and H₂ gas are supplied from the processing gas supply system 21 into the processing gas space 52 in the processing chamber 10 through the processing gas supply line 22. When the electrical characteristics of the SiC film need to be adjusted, TMA gas and/or N₂ gas is supplied, if necessary. A cooling gas such as Ar gas or the like is supplied from the cooling gas supply system 22 into the heat insulating space 53 through the cooling gas supply line 24.

Among the above-described processing gases, C₃H₈ gas has a high decomposition temperature of 1200°C or above. Since, however, the substrate W is heated to a high temperature ranging from, e.g., 1550°C to 1650°C as described above, the processing gas supplied into the processing space 51 is decomposed on the substrate W. Accordingly, the SiC film can be formed on the substrate W by epitaxial growth.

The heat insulator holding member 37 for holding the heat insulator 36 is spaced apart from the processing chamber 10 and the cooling gas is supplied into the heat insulating space 53. Therefore, the increase in the temperature of the processing chamber 10 can be effectively suppressed, which makes it possible to prevent damage inflicted on the processing chamber 10.

Hereinafter, the transferring device 170 will be described.

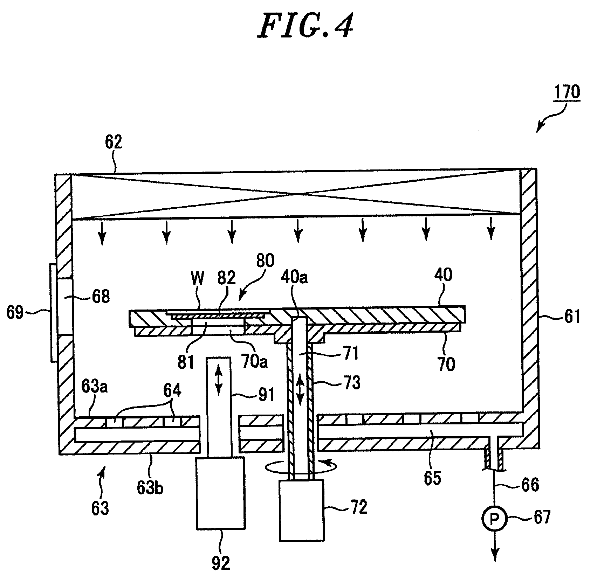

Fig. 4 is a cross sectional view of the transferring device 170. The transferring device 170 transfers (loads and unloads) the substrate W with respect to the substrate holder 40. The transferring device 170 includes a substantially rectangular parallelepiped chamber 61 having therein an atmospheric pressure space.

A fan filter unit FFU 62 is provided at an upper portion of the chamber 61. Air cleaned by the HEPA filter forms a downflow in the chamber 61. A bottom plate 63 of the chamber 61 includes an upper plate 63a and a lower plate 63b. A plurality of gas exhaust holes 64 is formed through the upper plate 63a. A gas exhaust space 65 is formed between the upper plate 63a and the lower plate 63b. A gas exhaust line 66 is connected to the lower plate 63b. A gas exhaust pump 67 is provided in the gas exhaust line 66. Accordingly, the downflow formed in the chamber 61 reaches the gas exhaust space 65 through the gas exhaust holes 64 and is discharged through the gas exhaust line 66.

A loading/unloading port 68 for loading/unloading the substrate W or the substrate holder 40 is provided at the sidewall of the chamber 61. The loading/unloading port 68 can be opened and closed by a shutter 69.

A supporting part 70 for supporting the substrate holder 40 is provided in the chamber 61. A hole is formed at a central portion of the supporting part 70. A rod 71 is inserted into the hole. The rod 71 extends to a position under the chamber 61. The rod 71 can be vertically moved and rotated by a driving unit 72. A supporting barrel 73 is provided at the outer side of the rod 71. The supporting part 70 is supported by the supporting barrel 73. The supporting barrel 73 is supported by the driving unit 72. An upper end of the rod 71 is fitted into the hole formed at the center of the substrate holder 40. The substrate holder 40 can be lifted in a state where the rod 71 is fitted in the hole. When the substrate holder 40 is transferred, the substrate holder 40 can be lifted by raising the central portion of the rod 71.

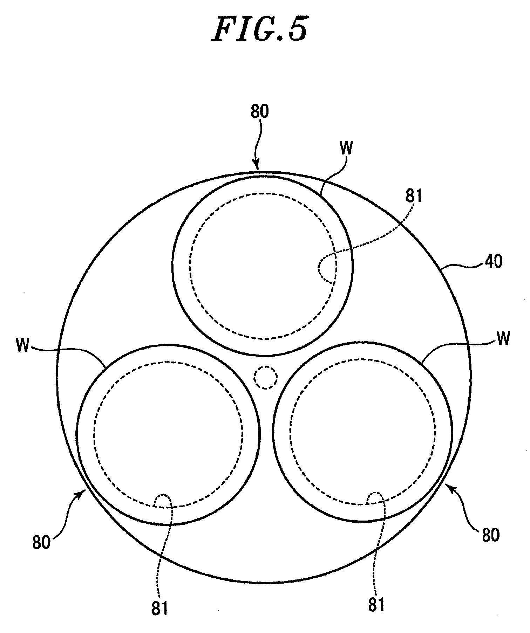

As shown in Fig. 5, the substrate holder 40 is configured to hold a plurality of (three in this example) substrates W. A plurality of substrate holding portions 80, each for holding a substrate W, is formed at the substrate holder 40. A hole 81 is formed at each of the substrate holding portions 80. As shown in Fig. 4, an elevation member 91 for moving up and down the substrate W is inserted into the hole 81 to pass therethrough.

The elevation member 91 is raised and lowered by an elevation cylinder 92. A hole 70a through which the elevation member 91 is raised and lowered is formed at a portion of the supporting part 70 which corresponds to the elevation member 91. The substrate holder 40 is received by the rod 71 in a state where the rod 71 is raised and, then, rotated by the driving unit 72 such that the position of the hole 81 of the substrate holding portion 80 having the substrate W to be transferred is made to correspond to the position of the hole 70a of the supporting part 70.

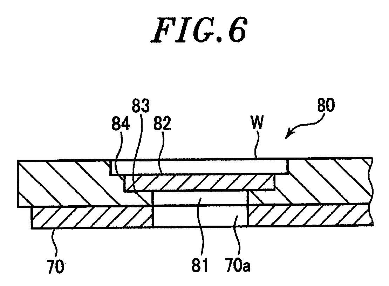

As shown in Fig. 6, the substrate holding portion 80 has a first step portion 83 for mounting thereon a shielding member 82 for shielding the hole 81 and a second step portion 84 for mounting thereon a substrate W. The first step portion 83 is formed around the hole 81. The second step portion 84 is formed at the outer upper side of the first step portion 83. When the shielding member 82 is mounted on the first step portion 83 and the substrate W is mounted on the second step portion 84, the state in which the substrate W is mounted on the shielding member 82 is obtained. The shielding member 82 has a diameter that is slightly smaller than that of the substrate W, so that it is possible to transfer only the substrate by the fork of the transfer unit.

The shielding member 82 has a function of preventing sublimates or the like from being adhered to the backside of the substrate W during the high-temperature film formation in the film forming apparatus 100, and a function of preventing transcription of the elevation member 91 or the like. The shielding member 82 may be made of, e.g., TaC, SiC, SiC coat graphite, graphite or the like, which is a material that is stable at a film forming temperature and does not react with a substrate. The shielding member 82 is consecutively used while the substrate processing is repeated in plural cycles and exchanged after a predetermined number of processing cycles have been performed. Whenever the substrate W is loaded into the substrate holder 40, the shielding member 82 may be unloaded from a separately provided shielding member carrier and set to the substrate holding portion 80.

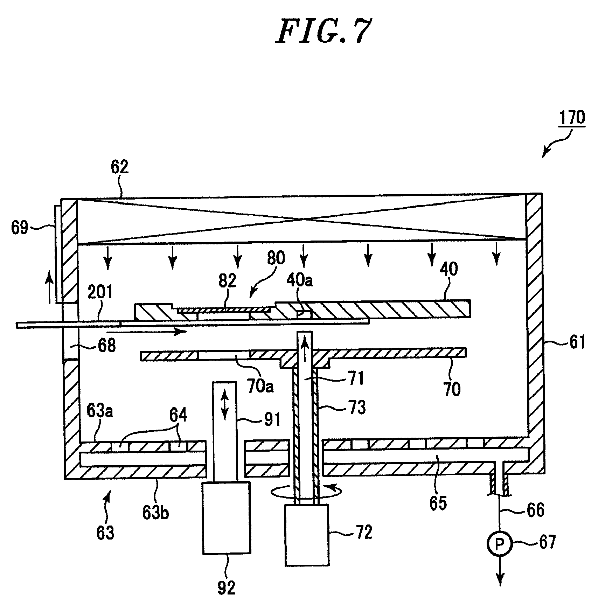

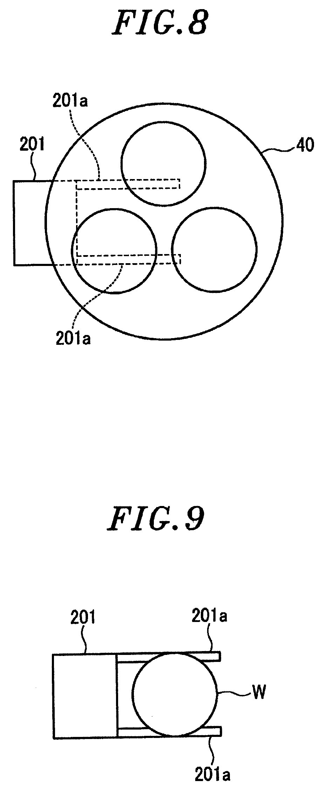

In the transferring device 170 configured as described above, the substrate holder 40 is mounted on a fork 201 of the transfer unit in the loading/unloading chamber 130 and loaded into the chamber 61 as shown in Fig. 7. As shown in Fig. 8, the fork 201 has two supporting members 201a that support the substrate holder 40 while avoiding the center of the substrate holder 40. At this time, the rod 71 is in a raised state. The fork 201 is lowered when the fork 201 reaches a position where a central hole 40a of the substrate holder 40 corresponds to the rod 71. The substrate holder 40 is supported by the rod 71 and rotated such that a specified substrate holding portion 80 is located at a position corresponding to the elevation member 91. The rod 71 is lowered and the substrate holder 40 is held on the supporting part 70.

Next, the loading the substrate W onto the substrate holder 40 is carried out. The substrate W is transferred by using the fork 201 used for transferring the substrate holder 40. In this case, the edge of the backside of the substrate W is supported by two supporting members 201a as shown in Fig. 9.

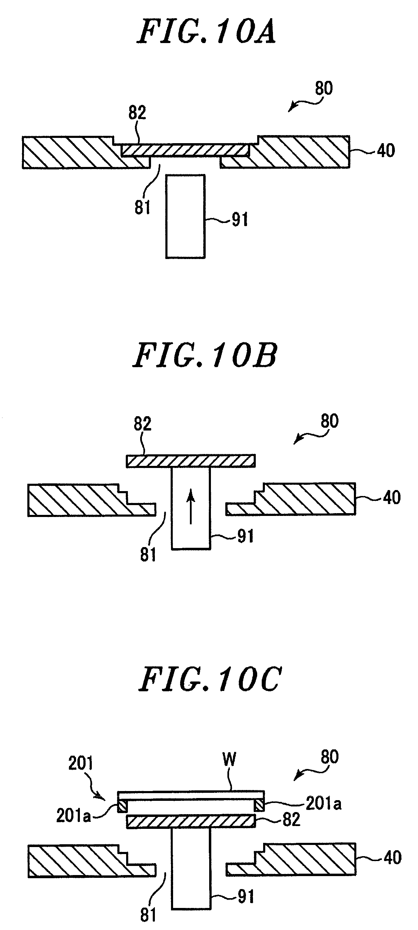

The loading operation of the substrate W will be described with reference to Figs. 10A to 10E.

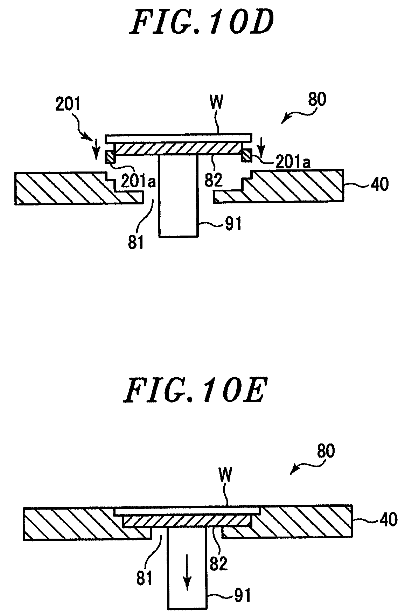

First, the shielding member 82 provided at the substrate holding portion 80 of the substrate holder 40 is raised by moving up the elevation member 91 from the state shown in Fig. 10A (see Fig. 10B). Then, the substrate W supported by the supporting members 201a of the fork 201 is loaded into the chamber 61 and transferred to a position corresponding to the raised shielding member 82 (see Fig. 10C). Next, the wafer W is mounted on the shielding member 82 by lowering the fork 201 (see Fig. 10D). Thereafter, the fork 201 is retreated and the shielding member 82 and the substrate W are lowered by the elevation member 91, so that the substrate W is loaded to the substrate holding portion 80 of the substrate holder 40 (see Fig. 10E).

By performing the above operations for a plurality of (three in this example) substrate holding portions 80, the delivery (loading) of the substrates W to the substrate holding portions 80 is completed.

After the loading of the substrates W to the substrate holder 40 is completed, the substrate holder 40 is raised by the rod 71 and received by the fork 201. The substrate holder 40 is unloaded from the chamber 61 and used for film formation.

The substrate holder 40 on which the substrates W subjected to the film formation are mounted is transferred into the chamber 61 of the transferring device 170 by the fork 201 and set to a predetermined position. Next, the substrates are unloaded.

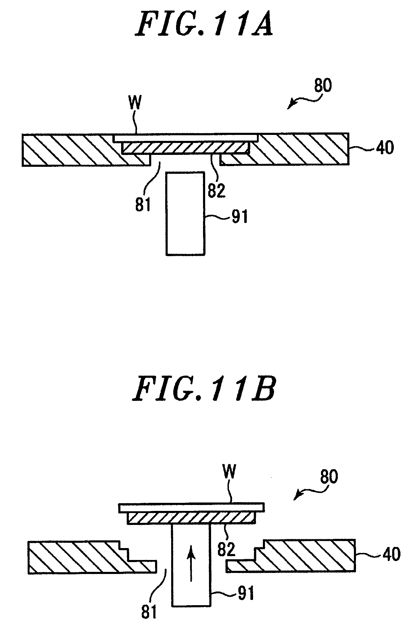

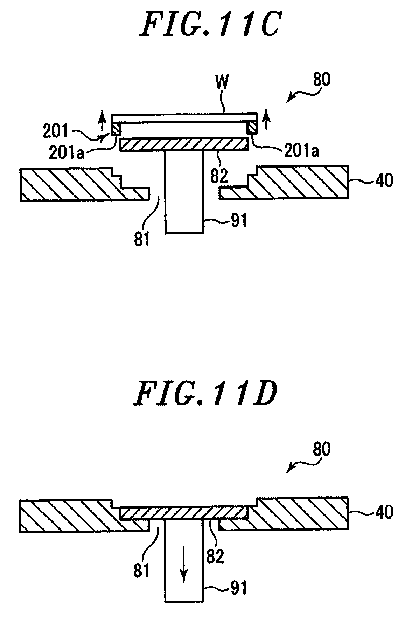

The unloading operation of the substrate W will be described with reference to Figs. 11A to 11D. Basically, the unloading operation is carried out in the reverse sequence of the loading operation as will be described below. First, the shielding member 82 and the substrate W are raised from the state shown in Fig. 11A by the elevation member 91 (see Fig. 11B). Next, the fork 201 is inserted to a position below the substrate W mounted on the shielding member 82, and only the substrate W is raised and unloaded from the chamber 61 by the fork 201 (see Fig. 11C). Then, the shielding member 82 is lowered by the elevation member 91 and returned to a specified position of the substrate holding portion 80 (see Fig. 11D).

By performing the above operations for a plurality of (three in this example) substrate holding portions 80, the unloading of the substrates W from the substrate holding portion 80 is completed.

Conventionally, the transfer, i.e., the loading and the unloading, of the substrate with respect to the holder is performed by an operator. Therefore, particles are generated and crystal defects occur in the formed film. As a result, the production yield decreases.

On the other hand, in the present embodiment, the transfer of the substrate W with respect to the substrate holder 40 is automatically performed. Therefore, the effect of particles generated by an operator's operation can be avoided. Since the transferring device 170 transfers the substrate W in a state where the downflow of clean air is formed, the effect of particles can be further reduced.

In case that the backside of the substrate is exposed, when the substrate supporting part or the heat insulator of the film forming apparatus is made of SiC, sublimates of SiC generated by close-spaced sublimation are adhered to the backside of the substrate by the high-temperature heating during the formation of the compound semiconductor film. In addition, undesired deposits are formed on the backside of the substrate by the processing gas for film formation. When the sublimates or the deposits are adhered onto the backside of the substrate, a resistance value is adversely affected during device manufacture or various measurements are adversely affected by the deposits. Besides, if the elevation member formed as a pin or a rod is brought into direct contact with the backside of the substrate during the transfer of the substrate, the problem of transcription of the elevation member may occur.

On the other hand, in the substrate holder 40 of the present embodiment, the shielding member 82 is provided at the backside of the substrate W, so that the backside of the substrate is not exposed. Therefore, it is possible to effectively suppress generation of sublimates or deposits on the backside of the substrate W during the film formation and also possible to effectively suppress the transcription of the elevation member 90 on the backside of the substrate W. Accordingly, it is possible to prevent a resistance value from being adversely affected during device manufacture or various measurements from being adversely affected by the deposits. In addition, the problem of transcription of the elevation member does not occur, so that the shape of the elevation member can be selected optionally.

The present invention may be variously modified without being limited to the above embodiments. For example, in the above embodiments, a SiC film is formed as a compound semiconductor film on the substrate. However, another compound semiconductor films such as a GaN film, a GaAs film, an AlN film or the like may be formed. In order to form a compound semiconductor film by epitaxial growth, a general substrate may be used as the substrate.

The above embodiments have described the case in which the substrate is transferred by the transferring device separately provided from the film forming apparatus. However, the substrate may be transferred by the film forming apparatus. In addition, the above embodiments have described, as an example, a semi-batch type processing system for performing a film forming process on a plurality of substrates mounted on the holder simultaneously. However, a single-sheet processing system for processing substrates one at a time may be employed.

### Description of Reference Numerals

- 10: processing chamber
- 12: gas exhaust line
- 14: vacuum pump
- 17: induction heating coil
- 20: gas supply unit
- 21: processing gas supply system
- 22: processing gas supply line
- 23: cooling gas supply system
- 24: cooling gas supply line
- 33: mounting table
- 36: insulator
- 40: substrate holder
- 61: chamber
- 62: FFU
- 70: supporting part
- 71: rod
- 72: driving unit
- 80: substrate holding portions
- 81: hole
- 82: shielding member
- 83: first step portion
- 84: second step portion
- 91: elevation member
- 92: elevation cylinder
- 100: film forming apparatus
- 110: transfer chamber
- 120: load-lock chamber
- 130: loading/unloading chamber
- 170: transferring device
- 180: control unit
- 200: film forming system
- 201: fork
- 201a: supporting members

## Claims

1. A transferring device for transferring a substrate for forming a compound semiconductor film thereon to a substrate holder, the transferring device comprising:
a supporting part configured to support the substrate holder;
an elevation member configured to raise and lower a substrate at a substrate holding portion of the substrate holder; and
a shielding member configured to be raised and lowered by the elevation member, the shielding member being interposed between the substrate and the elevation member when the elevation member receives the substrate, and shielding, at a backside of the substrate, a hole in the substrate holder through which the elevation member is inserted when the substrate is held on the substrate holding portion,
wherein in a state where the elevation member is raised, the substrate is mounted on the shielding member or the substrate on the shielding member is transferred therefrom.

2. The transferring device of claim 1, wherein the substrate holder includes a plurality of substrate holding portions.

3. The transferring device of claim 2, further comprising: a rotation unit configured to rotate the substrate holder to make each of the substrate holding portions correspond to the elevation member.

4. The transferring device of claim 1, wherein the transferring device is separately provided from an apparatus for forming a compound semiconductor film.

5. The transferring device of claim 1, wherein the shielding member is made of one of TaC, SiC, SiC coat graphite, and graphite.

6. The transferring device of claim 1, further comprising:
a chamber configured to accommodate the substrate holder and allow transfer of the substrate therein; and
a unit configured to form a downflow of clean air in the chamber.

7. A transferring method for transferring a substrate for forming a compound semiconductor film thereon, the transferring method comprising:
preparing a substrate holder including a substrate holding portion having a hole through which an elevation member configured to raise and lower a substrate is inserted;
shielding the hole by a shielding member;
raising the shielding member by raising the elevation member;
mounting the substrate on the shielding member; and
holding the substrate on the substrate holding portion in a state where the elevation member is lowered and the hole is shielded, at the backside of the substrate, by the shielding member.

8. The transferring method of claim 7, wherein the substrate holder includes a plurality of substrate holding portions.

9. The transferring method of claim 8, further comprising:
rotating the substrate holder in order to make one of the substrate holding portions correspond to the elevation member.

10. The transfer method of claim 7, wherein the shielding member is made of one of TaC, SiC, SiC coat graphite, and graphite.

11. The transferring method of claim 7, further comprising:
raising the shielding member and the substrate held on the substrate holding portion by raising the elevation member;
transporting the substrate from the shielding member;
and
lowering the shielding member by lowering the elevation member to shield the hole.

12. A film forming system comprising:
a transferring device configured to transfer a substrate for forming a compound semiconductor film thereon to a substrate holder including a plurality of substrate holding portions;
a film forming apparatus configured to form a compound semiconductor film on a plurality of substrates mounted on the substrate holder, into which the substrate holder on which the substrates are mounted by the transferring device is loaded; and
a transporting device configured to transport the substrate holder between the transferring device and the film forming apparatus,
wherein the transferring device includes:
a supporting part configured to support the substrate holder;
an elevation member configured to raise and lower a substrate at each of the substrate holding portions; and
a shielding member, configured to be raised and lowered by the elevation member, the shielding member being interposed between the substrate and the elevation member when the elevation member receives the substrate, and shielding, at a backside of the substrate, a hole in the substrate holder through which the elevation member is inserted when the substrate is held on the substrate holding portions,
wherein in a state where the elevation member is raised, the substrate is mounted on the shielding member or the substrate on the shielding member is transferred therefrom.

13. A method for forming a compound semiconductor film on a plurality of substrates for forming a compound semiconductor film thereon, the method comprising:
preparing a substrate holder including a plurality of substrate holding portions, each of which having a hole through which an elevation member configured to raise and lower a substrate is inserted;
shielding each of the holes by a shielding member;
raising the shielding member by raising the elevation member at one of the substrate holding portions;
mounting a substrate on the shielding member by a transporting device;
holding a substrate on each substrate holding portion in a state where the elevation member is lowered and the hole is shielded, at a backside of the substrate, by the shielding member; and
transporting the substrate holder on which the substrates are held to a film forming apparatus and forming a compound semiconductor film on the substrates.
